# FASCICULE DE BREVET EUROPEEN

(11) **EP 1 421 625 B1**
(45) Date de publication et mention de la délivrance du brevet: **17.10.2007**
(21) Numéro de dépôt: 02796334.7
(22) Date de dépôt: 30.08.2002
(51) Int. Cl.: H01L 27/146, H01L 31/0216

(54) **PROCEDE DE FABRICATION DE CAPTEUR D'IMAGE COULEUR AVEC SUBSTRAT DE SUPPORT SOUDE PLOT SUR PLOT**
VERFAHREN ZUR HERSTELLUNG EINES FARBBILDSENSORS MIT AUF DEM SUBSTRAT GEHALTENER, VERSCHWEISSTER VERBINDUNG-AUF-VERBINDUNG
METHOD FOR MAKING A COLOUR IMAGE SENSOR WITH SUPPORT SUBSTRATE WELDED CONNECTION-ON-CONNECTION

(30) Priorité: 31.08.2001 FR 0111337
(43) Date de publication de la demande: 26.05.2004
(73) Titulaire: E2V SEMICONDUCTORS, 38120 Saint Egreve (FR)
(72) Inventeur: POURQUIER, Eric, Thales Intellectual Property, 94117 Arcueil Cedex (FR); ROMMEVEAUX, Philippe, Thales Intellectual Property, 94117 Arcueil Cedex (FR)
(74) Mandataire: Guérin, Michel
(86) Numéro de dépôt international: PCT/FR2002/002980
(87) Numéro de publication internationale: WO 2003/019670

(56) Documents cités:
- EP-A- 1 094 511
- US-A- 5 144 747
- US-A- 5 561 295
- US-A- 5 665 607
- US-B1- 6 257 491

## Description

L'invention concerne les capteurs d'image électroniques, et notamment les capteurs de très petites dimensions permettant de réaliser des caméras miniatures, telles que celles qu'on peut vouloir incorporer à un téléphone portable.

Outre un encombrement très réduit, on souhaite que le capteur d'image ait une bonne sensibilité en faible lumière et de bonnes performances colorimétriques.

D'autre part, il est nécessaire de réaliser l'ensemble de la caméra par des procédés les plus économiques possibles pour ne pas aboutir à un coût rédhibitoire de l'appareil.

Pour y parvenir, on essaye d'une part de réaliser le capteur d'image et les circuits électroniques associés si possible sur un même substrat de silicium, et, d'autre part, on essaye de réaliser autant que possible les dépôts de couches diverses, les gravures, les traitements thermiques, etc. d'une manière collective sur une tranche de silicium (ou "wafer") comportant de nombreux capteurs identiques, avant de découper la tranche en capteurs individuels.

Cependant, les procédés de fabrication et les structures de capteur d'image qui ont été proposées jusqu'à maintenant ne donnent pas entièrement satisfaction de ce point de vue : les procédés de fabrication ne sont pas industriellement efficaces ; ils restent trop coûteux et de rendement trop faible pour des applications de grande série, ou bien les performances du capteur d'image ne sont pas suffisamment bonnes. Le document US-B-6,257,491 décrit un procédé de formation d'un dispositif optique. Le document EP-A-1094511 décrit un procédé d'amincissement de puces électroniques.

La présente invention vise à proposer un procédé de fabrication et un capteur d'image correspondant qui minimise les coûts de fabrication tout en présentant de bonnes qualités et notamment un faible encombrement, une bonne sensibilité et de bonnes performances colorimétriques.

A cet effet, l'invention propose un procédé de fabrication d'un capteur d'image, comprenant :
- la formation, sur la face avant d'une tranche semiconductrice, de préférence du silicium monocristallin, d'une série de zones actives comportant des circuits de détection d'image et correspondant chacune à un capteur d'image respectif, chaque zone active étant entourée de plots d'entrée/sortie,
- le report de la tranche par sa face avant contre la face avant d'un substrat de support,
- l'élimination de la majeure partie de l'épaisseur de la tranche semiconductrice, laissant subsister sur le substrat une fine couche semiconductrice comprenant les circuits de détection d'image,
ce procédé étant caractérisé en ce que :
- d'une part on dépose et on grave ultérieurement des couches de filtres de couleur sur la tranche semiconductrice ainsi amincie,
- d'autre part, le substrat comporte des plots de connexion disposés avec la même géométrie que les plots de chaque zone active pour venir en regard de ces plots lors du report pour souder un plot respectif du substrat à un plot correspondant de la tranche semiconductrice,
- et enfin, on découpe le substrat en capteurs individuels après le dépôt et la gravure des filtres colorés.

Le substrat peut être un simple substrat de support pour maintenir rigidement la tranche semiconductrice avant, pendant et après son amincissement.

Mais on peut aussi prévoir que le substrat qui porte des plots d'interconnexion porte aussi des conducteurs d'interconnexion et éventuellement aussi des éléments actifs ou passifs de circuit, par exemple des circuits de commande des circuits de détection d'image présents dans la tranche semiconductrice, ou encore des circuits de traitement de signal associés au capteur d'image.

Après amincissement de la tranche semiconductrice, on formera en principe dans l'épaisseur de la couche semiconductrice subsistante des ouvertures profondes allant jusqu'à la surface inférieure des plots de connexion qui ont été préalablement formés sur la tranche avant report sur le substrat. Ces ouvertures permettront d'accéder aux plots qui constitueront alors des plots d'entrée/sortie du capteur.

Le report de la tranche semiconductrice sur le substrat se fait par exemple par refusion de billes d'indium placées sur les plots, pendant que la tranche et le substrat sont en contact avec leurs plots en regard.

Les zones actives de la tranche peuvent comprendre à la fois une matrice d'éléments photosensibles, des circuits de commande de la matrice, et des circuits de traitement d'image associés recevant des signaux issus des éléments photosensibles de la zone active.

L'amincissement de la tranche après report sur le substrat et avant dépôt des filtres colorés peut se faire de plusieurs manières différentes : amincissement par rodage, amincissement chimique, combinaison des deux types (d'abord mécanique puis finition chimique, ou usinage mécanique en présence de produits chimiques) ; on peut aussi procéder à l'amincissement par fragilisation préalable de la tranche au niveau du plan de coupe désiré, notamment par implantation d'hydrogène en profondeur dans le plan de découpe désiré. Dans ce dernier cas, l'implantation d'hydrogène est faite à faible profondeur dans la tranche semiconductrice, avant le report de la tranche sur le substrat. L'amincissement est fait ensuite par un traitement thermique qui dissocie la tranche au niveau du plan de découpe implanté, laissant une fine couche semiconductrice en contact avec le substrat.

L'amincissement très important de la tranche fait passer l'épaisseur de celle-ci de plusieurs centaines de microns avant report sur le substrat à 10 à 20 microns ou même entre 3 et 10 microns après report sur le substrat. L'amincissement est un facteur de qualité important des capteurs puisqu'il augmente les performances colorimétriques et la sensibilité. Avec des capteurs non amincis, éclairés par le côté où sont formés de multiples couches isolantes et conductrices servant à la définition des circuits de détection d'image, la lumière ayant traversé un filtre coloré est dispersée sur des points photosensibles correspondant à des couleurs différentes, détériorant les performances colorimétriques. De plus, la sensibilité d'un capteur aminci est améliorée parce que les photons arrivent sur une plus large zone semiconductrice que dans les capteurs non amincis, n'étant pas arrêtés par les couches métalliques qui sont opaques et qui occupent une grande partie de la surface correspondant à chaque point photosensible.

On comprend que l'amincissement complique cependant les problèmes de fabrication du fait qu'après amincissement le silicium perd sa rigidité et devient très fragile, et que se pose de plus un problème de connexion des circuits de détection d'image avec l'extérieur. La solution selon l'invention permet de pallier cette difficulté et permet de fabriquer des capteurs d'image avec un bon rendement.

A titre d'exemple, l'épaisseur du substrat de support est d'environ 500 micromètres, pour un substrat de 15 à 20 centimètres de diamètre ; l'épaisseur de la tranche de silicium est de 500 à 1000 micromètres avant amincissement (diamètre de 15 à 30 centimètres), puis de 3 à 20 micromètres après amincissement.

Une substance de remplissage (résine) sera en général prévue dans les intervalles entre les plots de connexion pour améliorer la rigidité de la tenue de la liaison entre le substrat et la tranche de silicium. Cette matière de remplissage protège les éléments de circuit actifs de la tranche.

L'éclairage du capteur se fait du côté de la couche de silicium amincie et non du côté du substrat de support.

Enfin, sur la couche de silicium amincie, recouverte des filtres de couleur, on peut placer une feuille de matière transparente ou une couche de passivation. Ces opérations peuvent se faire soit sur les capteurs individuels découpés soit encore, de préférence, sur le substrat en tranche, avant découpe en capteurs individuels.

D'autres caractéristiques et avantages de l'invention apparaîtront à la lecture de la description détaillée qui suit et qui est faite en référence aux dessins annexés dans lesquels :
- la figure 1 représente la structure d'un capteur d'image réalisé sur une tranche de silicium avant mise en place de filtres colorés ;
- la figure 2 représente l'opération de report de la tranche de silicium par sa face avant sur un substrat de support ;
- la figure 3 représente le substrat de support avec la tranche de silicium après amincissement de la tranche ;
- la figure 4 représente le substrat de support, portant une couche de silicium amincie sur laquelle on a déposé une mosaïque de filtres colorés et dans laquelle on a formé des ouvertures d'accès à des plots de connexion.

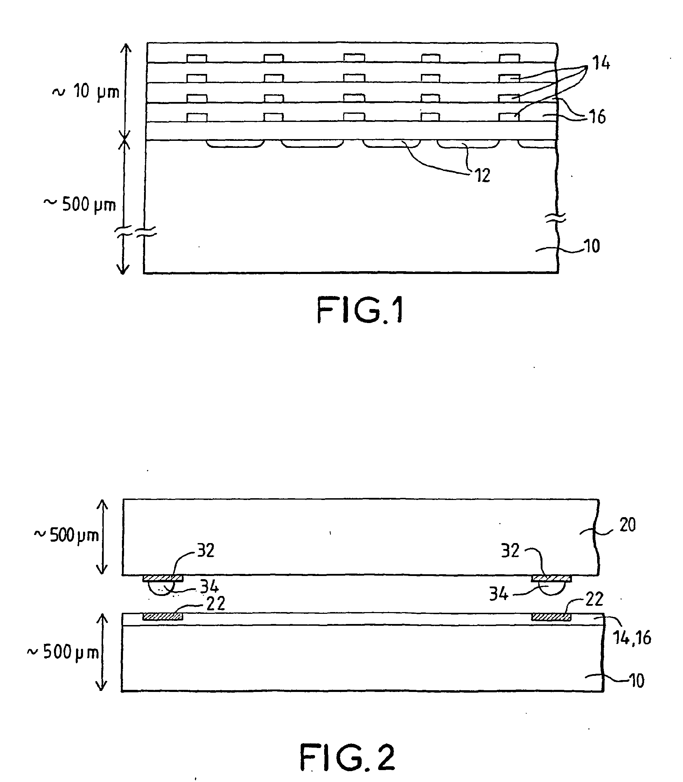

La figure 1 représente la structure générale d'une tranche de silicium sur laquelle on a réalisé par des techniques classiques les circuits de détection d'image d'une multiplicité de capteurs d'image.

La tranche de silicium 10 (ou "wafer") a une épaisseur de plusieurs centaines de micromètres, pour un diamètre de 150 à 300 millimètres.

Les circuits de détection d'image (matrice de points photosensibles, transistors, interconnexions) sont fabriqués sur une face de la tranche de silicium, qu'on peut appeler face avant et qui est la face supérieure sur la figure 1. La fabrication implique d'une part des diffusions et implantations diverses dans le silicium, à partir de la face supérieure de la tranche, pour former notamment des zones photosensibles 12, et d'autre part des dépôts et gravures successives de couches conductrices 14 et de couches isolantes 16 formant un empilement au-dessus des zones photosensibles 12. Les couches isolantes et conductrices font partie des circuits de détection d'image et permettent le recueil des charges électriques engendrées dans les zones photosensibles par une image projetée sur le capteur.

Une des couches conductrices 14, en principe la couche déposée en dernier, sert à former des plots d'entrée/sortie de chaque capteur individuel (plots non visibles sur la figure 1) autour d'une zone active comprenant la matrice de points photosensibles. Ces plots affleurent à la surface supérieure de la tranche de silicium qui est éventuellement recouverte d'une couche de planarisation destinée à effacer les reliefs et les creux présents sur la surface de la tranche après formation de l'empilement de couches gravées 14 et 16.

Si le capteur était réalisé avec une technologie classique, on déposerait alors à la surface de la tranche une mosaïque de filtres colorés.

Selon l'invention, on ne dépose pas de filtres colorés à ce stade mais on reporte la tranche par sa face avant sur un substrat de support 20 (figure 2). Le substrat de support est une tranche de même diamètre que la tranche 10 et d'épaisseur analogue pour assurer la rigidité de la structure pendant la fabrication ; il peut d'ailleurs être constitué par une autre tranche de silicium.

Sur la figure 2, on a représenté la structure à une échelle plus petite qu'à la figure 1, pour montrer l'ensemble d'un capteur individuel comportant une zone active ZA et des plots de connexion 22 autour de la zone active ZA.

Le substrat de support 20 comporte sur sa face avant (tournée vers le bas sur la figure 2) des plots conducteurs 32 qui sont disposés exactement en regard des plots 22. Le report de la tranche de silicium 10 sur le substrat 20 se fait par soudure des plots 22 sur les plots 32 sur toute la surface de la tranche de silicium.

La soudure peut s'effectuer par refusion de billes (par exemple en indium) 34 préalablement déposées et soudées sur les plots 22 de la tranche ou sur les plots 32 du substrat de support.

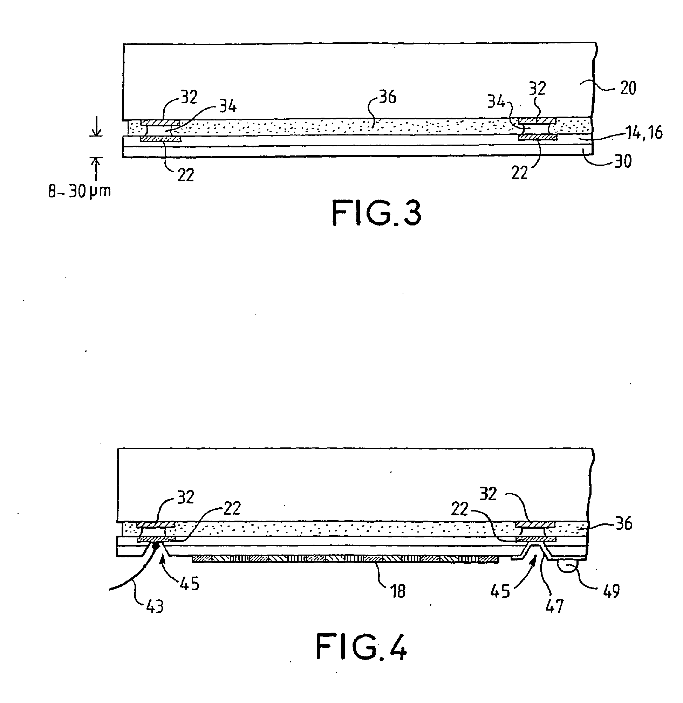

Comme on le voit sur la figure 3, une résine de remplissage 36 est de préférence prévue entre la tranche et le substrat, dans l'espace non occupé par les plots 22 et 32. Cette résine sert à assurer la tenue mécanique de la structure après l'opération d'amincissement de la tranche de silicium.

Après report de la tranche de silicium par sa face avant sur la tranche de support, on élimine la majeure partie de l'épaisseur de la tranche de silicium 10 pour n'en laisser subsister qu'une épaisseur d'environ 8 à 30 micromètres, incluant l'épaisseur de l'empilement de couches 14, 16. Ce qui subsiste de la tranche de silicium n'est plus qu'une superposition de quelques micromètres (par exemple 5 à 10) pour l'empilement de couches 14, 16 et environ 3 à 20 micromètres pour l'épaisseur de silicium subsistante, incluant les zones photosensibles 12. L'épaisseur subsistante est la couche 30 de la figure 3 contenant les zones photosensibles 12 de la figure 1.

L'opération d'amincissement peut se faire par usinage mécanique (rodage) terminé par un usinage chimique, ou par usinage chimique uniquement, ou par usinage mécanique en présence de produits chimiques, ou encore par un procédé de séparation particulier nécessitant au préalable une implantation d'une impureté de fragilisation dans le plan qui délimitera la couche de silicium amincie.

Dans le cas de cette séparation par implantation d'impuretés, il faut effectuer l'implantation avant le report de la tranche de silicium sur la tranche de support. En effet, l'implantation se fait par la face avant de la tranche de silicium, sur toute la surface de celle-ci et à une profondeur qui définira le plan de découpe. L'implantation préalable est de préférence une implantation d'hydrogène. Elle peut être effectuée à divers stades de la fabrication de la tranche, mais la séparation de l'épaisseur de la tranche selon le plan de découpe implanté ne se fait que lorsque la tranche de silicium a été rapportée sur la tranche de support.

La surface supérieure de la couche de silicium amincie 30 (face tournée vers le bas sur la figure 3) peut être traitée (rodage fin, nettoyage chimique, polissage mécano-chimique, etc.) pour éliminer les défauts de surface, aboutissant à une tranche de multiples capteurs dont la structure générale est celle de la figure 3.

Une mosaïque de filtres colorés 18 est alors déposée sur la surface de la couche 30 (figure 4). Toutefois, on peut, préalablement au dépôt des filtres colorés, déposer une ou plusieurs autres couches telles que des couches de passivation, couches anti-reflets, couches d'activation électrique, etc.

Si nécessaire une couche de planarisation 24 est déposée sur la mosaïque de filtres. Elle doit être transparente.

Des ouvertures 45 sont creusées dans la tranche de silicium amincie, avant ou après mise en place des filtres colorés, pour permettre un accès électrique à l'arrière des plots de connexion 22 qui avaient été formés sur la face avant de la tranche de silicium.

L'accès électrique peut se faire directement à l'intérieur de ces ouvertures comme cela est visible sur la partie gauche de la figure 4 ; on vient alors souder des fils 43 sur les plots à l'intérieur des ouvertures 45. L'accès électrique peut aussi se faire indirectement en redéposant une couche conductrice 47 qui vient en contact, à l'intérieur des ouvertures 45, avec les plots 22 et qui comporte une partie à l'extérieur des ouvertures 45. Cette variante est représentée sur la partie droite de la figure 4 ; elle permet notamment un report de type "flip-chip" (puce retournée) sur une carte de circuit imprimé. Des bossages conducteurs 49 peuvent être formés à cet effet sur les métallisations 47.

Après mise en place des filtres colorés et formation des ouvertures d'accès aux plots de connexion 22, un film de verre, ou une lentille individuelle pour le capteur d'image, ou une matrice de microlentilles de même pas d'espacement que les filtres colorés 18 peuvent être déposés sur la face arrière (celle qui sera éclairée) de la structure. Ces éléments ne sont pas représentés sur les figures.

On notera que la structure formée sur le substrat 20 peut être testée sur tranche par l'intermédiaire des plots de connexion ainsi réalisés. Le test peut être fait en présence de lumière, de motifs d'image, etc.

La structure n'est découpée en capteurs individuels en vue d'une encapsulation qu'à la fin de ce processus de fabrication.

Enfin, le substrat 20 peut être lui-même constitué par un substrat de silicium dans lequel on a formé des interconnexions ou même des circuits intégrés destinés à être associés aux circuits de détection d'image du capteur (par exemple des circuits de commande de séquencement des signaux de commande de lignes et colonnes de la matrice photosensible contenue dans la tranche de silicium 10). Ce sont alors les plots d'entrée/sortie de ces circuits intégrés contenus dans le substrat 20 qui peuvent à la fois servir de points de raccordement électrique avec des plots d'entrée/sortie des circuits de détection d'image du capteur et servir de points de soudure pour le report de la tranche 10 sur le substrat 20.

## Revendications

1. Procédé de fabrication d'un capteur d'image, comprenant :
- la formation, sur la face avant d'une tranche semiconductrice (10), d'une série de zones actives (ZA) comportant des circuits de détection d'image et correspondant chacune à un capteur d'image respectif, chaque zone active étant entourée de plots d'entrée/sortie (22),
- le report de la tranche par sa face avant contre la face avant d'un substrat de support (20),
- l'élimination de la majeure partie de l'épaisseur de la tranche semiconductrice, laissant subsister sur le substrat une fine couche semiconductrice (30) comprenant les circuits de détection d'image,
ce procédé étant **caractérisé en ce que** :
- d'une part on dépose et on grave ultérieurement des couches de filtres de couleur (18) sur la tranche semiconductrice ainsi amincie,
- d'autre part, le substrat comporte des plots de connexion (32) disposés avec la même géométrie que les plots (22) de chaque zone active pour venir en regard de ces plots (22) lors du report, pour souder un plot respectif (32) du substrat (20) à un plot correspondant (22) de la tranche semiconductrice (10),
- et enfin, on découpe le substrat en capteurs individuels après le dépôt et la gravure des filtres colorés.

2. Procédé selon la revendication 1, **caractérisé en ce que** le substrat de support (20) porte des circuits associés aux circuits de détection d'image contenus dans la tranche semiconductrice.

3. Procédé selon l'une des revendications 1 et 2, **caractérisé en ce que**, après amincissement de la tranche semiconductrice, on forme dans l'épaisseur de la couche semiconductrice subsistante (30) des ouvertures (45) profondes allant jusqu'à la surface inférieure des plots de connexion (22) qui ont été préalablement formés sur la tranche (10) avant report sur le substrat.

4. Procédé selon l'une des revendications 1 à 3, **caractérisé en ce que** l'épaisseur de couche semiconductrice (30) subsistant après amincissement est d'environ 5 à 20 micromètres.

5. Procédé selon l'une des revendications 1 à 4, **caractérisé en ce qu'**une substance de remplissage (36) est prévue dans les intervalles entre les plots de connexion (22) pour améliorer la tenue de la liaison entre le substrat et la tranche semiconductrice.

6. Procédé selon l'une des revendications 1 à 5, **caractérisé en ce que**, sur la couche semiconductrice amincie (30), recouverte des filtres de couleur (18), on place une feuille de matière transparente ou une couche de passivation.

## Claims

1. Process for fabricating an image sensor comprising:
- formation, on the front face of a semiconductor wafer (10), of a series of active zones (ZA) comprising image detection circuits and each corresponding to a respective image sensor, each active zone being surrounded by input/output pads (22);
- bonding of the wafer via its front face to the front face of a support substrate (20); and
- removal of most of the thickness of the semiconductor wafer, leaving behind on the substrate a thin semiconductor layer (30) comprising the image detection circuits,
this process being **characterized in that**:
- firstly, layers of colour filters (18) are deposited on the semiconductor wafer thus thinned and are subsequently etched;
- secondly, the substrate includes connection pads (32) placed with the same geometry as the pads (22) of each active zone so as to face these pads (22) during bonding, in order to bond a respective pad (32) on the substrate (20) to a corresponding pad (22) on the semiconductor wafer (10); and finally,
- the substrate is diced into individual sensors after deposition and etching of the colour filters.

2. Process according to Claim 1, **characterized in that** the support substrate (20) bears circuits associated with the image detection circuits contained in the semiconductor wafer.

3. Process according to either of Claims 1 and 2, **characterized in that**, after the semiconductor wafer has been thinned, deep apertures (45) are formed in the thickness of the remaining semiconductor layer (30), said apertures going down to the lower surface of the connection pads (22) that were formed beforehand on the wafer (10) before it is bonded to the substrate.

4. Process according to one of Claims 1 to 3, **characterized in that** the thickness of the semiconductor layer (30) remaining after the thinning operation is about 5 to 20 microns.

5. Process according to one of Claims 1 to 4, **characterized in that** a filling substance (36) is provided in the gaps between the connection pads (22) in order to improve the strength of the bond between the substrate and the semiconductor wafer.

6. Process according to one of Claims 1 to 5, **characterized in that** a sheet of transparent material or a passivation layer is placed on the thinned semiconductor layer (30) covered with the colour filters (18).

## Patentansprüche

1. Verfahren zur Herstellung eines Bildsensors, das aufweist:
- die Bildung, auf der Vorderseite einer Halbleiterscheibe (10), einer Reihe von aktiven Zonen (ZA), die Bilderfassungsschaltungen aufweisen und je einem Bildsensor entsprechen, wobei jede aktive Zone von Eingangs-/Ausgangs-Anschlusskontakten (22) umgeben ist,
- den Übertrag der Scheibe mit ihrer Vorderseite auf die Vorderseite eines Trägersubstrats (20),
- das Entfernen des größten Teils der Dicke der Halbleiterscheibe, wobei auf dem Substrat eine dünne Halbleiterschicht (30) gelassen wird, die die Bilderfassungsschaltungen enthält,
wobei dieses Verfahren **dadurch gekennzeichnet ist, dass**:
- einerseits auf die so verdünnte Halbleiterscheibe Schichten von Farbfiltern (18) aufgebracht und später geätzt werden,
- andererseits das Substrat Anschlusskontakte (32) aufweist, die mit der gleichen Geometrie wie die Anschlusskontakte (22) jeder aktiven Zone angeordnet sind, um beim Übertrag gegenüber diesen Anschlusskontakten (22) angeordnet zu werden, um einen jeweiligen Anschlusskontakt (32) des Substrats (20) an einen entsprechenden Anschlusskontakt (22) der Halbleiterscheibe (10) zu schweißen,
- und schließlich nach dem Aufbringen und dem Ätzen der Farbfilter das Substrat in einzelne Sensoren zerschnitten wird.

2. Verfahren nach Anspruch 1, **dadurch gekennzeichnet, dass** das Trägersubstrat (20) Schaltungen trägt, die den in der Halbleiterscheibe enthaltenen Bilderfassungsschaltungen zugeordnet sind.

3. Verfahren nach einem der Ansprüche 1 und 2, **dadurch gekennzeichnet, dass** nach der Verdünnung der Halbleiterscheibe in der Dicke der verbleibenden Halbleiterschicht (30) tiefe Öffnungen (45) geformt werden, die bis zur Unterseite der Anschlusskontakte (22) gehen, die vorher auf der Scheibe (10) vor dem Übertrag auf das Substrat geformt wurden.

4. Verfahren nach einem der Ansprüche 1 bis 3, **dadurch gekennzeichnet, dass** die Halbleiterschichtdicke (30), die nach der Verdünnung verbleibt, etwa 5 bis 20 Mikrometer beträgt.

5. Verfahren nach einem der Ansprüche 1 bis 4, **dadurch gekennzeichnet, dass** eine Füllsubstanz (36) in den zwischenräumen zwischen den Anschlusskontakten (22) vorgesehen ist, um den Halt der Verbindung zwischen dem Substrat und der Halbleiterscheibe zu verbessern.

6. Verfahren nach einem der Ansprüche 1 bis 5, **dadurch gekennzeichnet, dass** auf die mit den Farbfiltern (18) bedeckte verdünnte Halbleiterschicht (30) eine Folie aus einem transparenten Stoff oder eine Passivierungsschicht aufgebracht wird.
